# EUROPEAN PATENT APPLICATION

(11) **EP 4 568 431 A1**
(43) Date of publication of application: **11.06.2025**
(21) Application number: 23849007.2
(22) Date of filing: 25.05.2023
(51) Int. Cl.: H05K 5/02, H05K 5/03, B44C 5/00, B44C 5/04

(54) **DECORATIVE SUBSTRATE AND PREPARATION METHOD THEREFOR, COVER PLATE AND ELECTRONIC DEVICE**

(30) Priority: 03.08.2022 CN 202210929657
(71) Applicant: BYD Company Limited, Shenzhen, Guangdong 518118 (CN)
(72) Inventor: ZHAO, Lihong, Shenzhen, Guangdong 518118 (CN); ZHU, Qiyu, Shenzhen, Guangdong 518118 (CN); GAO, Wenquan, Shenzhen, Guangdong 518118 (CN); LUO, Wenhai, Shenzhen, Guangdong 518118 (CN)
(74) Representative: Mathys & Squire
(86) International application number: PCT/CN2023/096305
(87) International publication number: WO 2024/027297

(57) **Abstract**

The present application provides a decorative substrate and a preparation method therefor, a cover plate and an electronic device. A decorative substrate comprises a base material and a texture layer arranged on a surface of the base material. The texture layer is provided with a plurality of protrusions arranged in an array. A first direction is any direction in a plane where the texture layer is located. Each protrusion comprises a protrusion bottom surface and a vertex, wherein in the first direction, the distances between the projections of the vertices of the plurality of protrusions on the protrusion bottom surfaces and the centers of the protrusion bottom surfaces vary gradually; and/or in the first direction, the heights of the vertices of the plurality of protrusions relative to the protrusion bottom surfaces vary gradually.

## Description

### CROSS-REFERENCE TO RELATED APPLICATIONS

The present disclosure claims priority to Chinese Patent Application No. 202210929657.0 filed on August 3, 2022 and entitled "DECORATIVE SUBSTRATE, AND PREPARATION METHOD AND APPLICATION THEREOF ", which is incorporated herein by reference in its entirety.

### FIELD

The present disclosure relates to the field of decoration technologies, and in particular, to a decorative substrate and a preparation method therefor, a cover plate and an electronic device.

### BACKGROUND

As a new type of decorative material, the gradient color decorative film is widely used in electronic equipment and other fields. However, the existing gradient color decorative film mainly achieves the color change through coating. The gradient color change is limited by the structure of the coating, and the gradient color change is relatively fixed and simple, and the gradient color decorative film is the same gradient color at different angles, and the color change lacks a three-dimensional quality, failing to meet consumer needs.

### SUMMARY

Intended to resolve the above problems, the present disclosure provides a decorative substrate, which has different color gradients under different viewing angles, so as to show a good decorative effect.

The first aspect of the present disclosure provides a decorative substrate, the decorative substrate includes a base material and a texture layer arranged on a surface of the base material, the texture layer is provided with a plurality of protrusions arranged in an array, and a first direction is any direction in a plane where the texture layer is located;

protrusion includes a protrusion bottom surface and a vertex, wherein in the first direction, the distances between the projections of the vertices of the plurality of protrusions on the protrusion bottom surfaces and the centers of the protrusion bottom surfaces vary gradually; and/or in the first direction, the heights of the vertices of the plurality of protrusions relative to the protrusion bottom surfaces vary gradually.

In the present disclosure, the plurality of protrusions in the texture layer have regular changing structures, so that the light can reflect, scatter, refraction or act other effects in the protrusions of different structures, and then reflect the light of different intensity, presenting a change in brightness and scatter out different colors, presenting the effect of gradual color. The decorative substrate of the structure can show dynamic color changes under different viewing angles, that is, it has a real-time changing gradient effect, which greatly improves the decorative effect.

In an example, the heights of the vertices of the plurality of protrusions relative to the protrusion bottom surfaces vary gradually in the first direction; and within every 1 cm distance in the first direction, the height variations of the vertices of the plurality of protrusions relative to the protrusion bottom surfaces are in the range of 0.2 µm to 6 µm.

In an example, the shape of the protrusion bottom surface includes any one of a polygon or a circle; in the first direction, distances between projections of the vertices of the plurality of protrusions on the protrusion bottom surfaces and centers of the protrusion bottom surfaces vary gradually; and within every 1 cm distance in the first direction, distance variations between projections of the vertices of the plurality of protrusions on the protrusion bottom surfaces and centers of the protrusion bottom surfaces are in the range of 1 µm to 200 µm.

In an example, the distance variation between the adjacent protrusions is the range of 1 µm to 10mm.

In an example, the shape of the protrusion bottom surface is a circle, and the radius of the protrusion bottom surface 112 is in the range of 1µm to 10mm.

In an example, the shape of the protrusion bottom surface is a polygon, and the radius of the outer circle(110) of the protrusion bottom surface is in the range of 1µm to 10mm.

In an example, the shape of the protrusion bottom surface is a circle, and the ratio of the radius of the protrusion bottom surface to the distance between the adjacent protrusions is (2 to 3):1.

In an example, the shape of the protrusion bottom surface is a polygon, and the ratio of the radius of the outer circle of the protrusion bottom surface to the distance between the adjacent protrusions is (2 to 3):1

In an example, the height of the vertex of the protrusion relative to the protrusion bottom surface is in the range of 0.1 µm to 20µm.

In an example, the shape of the protrusion bottom surface is a circle, and the radii of the plurality of protrusion bottom surfaces vary gradually in a second direction; and the second direction is any direction in the plane where the texture layer is located.

In an example, the shape of the protrusion bottom surface is a polygon, and the radii of the outer circle of the plurality of protrusion bottom surfaces vary gradually in the second direction; and the second direction is any direction in the plane where the texture layer is located.

In an example, the shape of the protrusion bottom surface is a polygon, and the plurality of protrusion bottom surfaces have a first array direction and a second array direction, the first array direction is perpendicular to the second array direction, and the plurality of protrusion bottom surfaces have a relative rotation angle that vary gradually relative to the first array direction or relative to the second array direction.

In an example, the shape of the side surface of the protrusion is any one of a flat, straight or curved surface.

In an example, in the first direction, the projections of the vertices of the plurality of protrusions on the protrusion bottom surfaces are connected to form an arrangement path of the vertices of the protrusions, and the arrangement path includes a straight path and/or a curved path.

In an example, the first array direction is defined as the array direction of the plurality of protrusions, and the shape of the protrusion bottom surface is a quadrilateral, in the first array direction, the projections of the vertices of the plurality of protrusions on the protrusion bottom surfaces are arranged in sequence along the diagonal of the quadrilateral.

In an example, the first array direction is defined as the array direction of the plurality of protrusions, and the shape of the protrusion bottom surface is a quadrilateral, in the first array direction, the projections of the vertices of the plurality of protrusions on the protrusion bottom surfaces are arranged in sequence along a predetermined line segment, and the predetermined line segment is a line segment parallel to the side length of the quadrilateral.

In an example, in the first direction, the projections of the vertices of the plurality of protrusions on the protrusion bottom surfaces are projected onto the same axis of the protrusion bottom surface passing through the center of the protrusion bottom surface.

In an example, the axis includes the axis of symmetry of the protrusion bottom surface or a line segment passing through the center of the protrusion bottom surface, wherein the line segment is a line connecting any two points on the circumference of the protrusion bottom surface.

In an example, the plurality of protrusion bottom surfaces have a first array direction and a second array direction, and the first array direction is perpendicular to the second array direction, the sizes of the protrusion bottom surfaces of the plurality of the protrusions decrease gradually in the first array direction and/or the second array, and the distance between the adjacent protrusions increases gradually.

In an example, the plurality of protrusion bottom surfaces have a first array direction and a second array direction, and the first array direction is perpendicular to the second array direction, in the first array direction, the sizes of the protrusion bottom surfaces of the plurality of protrusions decrease gradually, and within every 1 cm distance in the first array direction, the size variations of the protrusion bottom surfaces of the plurality of protrusions is in the range of 0.1µm to 100µm.

In an example, the decorative substrate further includes a finishing layer, the finishing layer includes one or more of a color developing layer, a frosted layer, and a glitter layer, and the finishing layer is set on the surface of the texture layer and/or the base material.

The second aspect of the present disclosure provides a method for preparing a decorative substrate, which includes the following steps:
forming a texture layer on the surface of the base material to obtain the decorative substrate, the preparation method of the texture layer includes one or more of transfer printing, etching, and hot press molding; the surface of the texture layer is provided with the plurality of protrusions arranged in an array; a first direction is any direction in a plane where the texture layer is located;
protrusion includes a protrusion bottom surface and a vertex, in the first direction, distances between projections of the vertices of the plurality of protrusions on the protrusion bottom surfaces and centers of the protrusion bottom surfaces vary gradually;
and/or in the first direction, the heights of the vertices of the plurality of protrusions relative to the protrusion bottom surfaces vary gradually.

The preparation method provided by the present disclosure is simple and easy to operate, and the process is mature and convenient for industrial production.

The third aspect of the present disclosure provides a cover plate, which includes the decorative substrate according to the first aspect of the present disclosure and a base body, and the decorative substrate is arranged on the surface of the base body.

The fourth aspect of the present disclosure provides an electronic device, which includes the cover plate according to the third aspect of the present disclosure.

### BRIEF DESCRIPTION OF THE DRAWINGS

FIG. 1 is a structural diagram of the decorative substrate according to an example of the present disclosure;
FIG. 2 is a structural diagram of the texture layer according to an example of the present disclosure;
FIG. 3 is a structural diagram of the texture layer according to an example of the present disclosure;
FIG. 4 is a structural diagram of the texture layer according to an example of the present disclosure;
FIG. 5A is a structural diagram of a straight-edge protrusion according to an example of the present disclosure;
FIG. 5B is a structural diagram of a curved-edge protrusion according to an example of the present disclosure;
FIG. 5C is a structural diagram of a curved-edge protrusion according to another example of the present disclosure;
FIG. 6A is a structural diagram of an array arrangement along the S-shaped direction of the protrusions according to an example of the present disclosure;
FIG. 6B is a structural diagram of the array arrangement along the M-shaped direction of the protrusions according to another example of the present disclosure;
FIG. 7 is a structural diagram of a ring array according to an example of the present disclosure;
FIG. 8 is a schematic diagram of the stereoscopic structure of the protrusion according to an example of the present disclosure;
FIG. 9 is a structural diagram of a protrusion bottom surface of the protrusion according to an example of the present disclosure;
FIG. 10 is a structural diagram of the change of the protrusion structure according to an example of the present disclosure;
FIG. 11 is a structural diagram of the change of the protrusion structure according to an example of the present disclosure;
FIG. 12 is a structural diagram of the change of the protrusion structure according to an example of the present disclosure;
FIG. 13A is a schematic diagram of the arrangement of the plurality of protrusions according to an example of the present disclosure;
FIG. 13B is a structural diagram of the position changes of the projections of the vertices of the plurality of protrusions in FIG. 13A on the protrusion bottom surfaces;
FIG. 14A is a schematic diagram of the arrangement of the plurality of protrusions according to another example of the present disclosure;
FIG. 14B is a structural diagram of the position changes of the projections of the vertices of the plurality of protrusions in FIG. 14A on the protrusion bottom surfaces;
FIG. 15A is a schematic diagram of the arrangement of the plurality of protrusions according to yet another example of the present disclosure;
FIG. 15B is a structural diagram of the height variations of the vertices of the plurality of protrusions in FIG. 15A;
FIG. 16 is a structural diagram of the texture layer according to an example of the present disclosure;
FIG. 17 is a structural diagram of the texture layer according to an example of the present disclosure;
FIG. 18 is a structural diagram of the texture layer according to an example of the present disclosure;
FIG. 19 is a structural diagram of the texture layer for an example of the present disclosure;
FIG. 20 is a structural diagram of the texture layer provided by an example of the present disclosure;
FIG. 21 is a structural diagram of the texture layer according to an example of the present disclosure;
FIG. 22 is a structural diagram of the texture layer according to an example of the present disclosure;
FIG. 23 is a structural diagram of the texture layer according to an example of the present disclosure;
FIG. 24 is a structural diagram of the texture layer provided by an example of the present disclosure;
FIG. 25 is a structural diagram of the texture layer provided by an example of the present disclosure;
FIG. 26 is a structural diagram of the electronic equipment according to an example of the present disclosure;
FIG. 27 is a top view of the decorative substrate according to example 1 of the present disclosure;
FIG. 28 is an effect diagram of the decorative substrate according to example 1 of the present disclosure;
FIG. 29 is a top view of the decorative substrate provided in example 2 of the present disclosure;
FIG. 30 is an effect diagram of the decorative substrate provided in example 2 of the present disclosure;
FIG. 31 is a top view of the decorative substrate according to example 3 of the present disclosure;
FIG. 32 is a top view of the decorative substrate provided in example 4 of the present disclosure.

### DETAILED DESCRIPTION

The technical scheme in the examples of the present disclosure will be clearly and completely described in combination with the drawings attached to the examples of present disclosure. Obviously, the examples described are only part of the examples of the present disclosure, but not all examples. Based on the examples in the present disclosure, all other examples obtained by a person skilled in the art without creative work can be fall within the scope of protection of the present application.

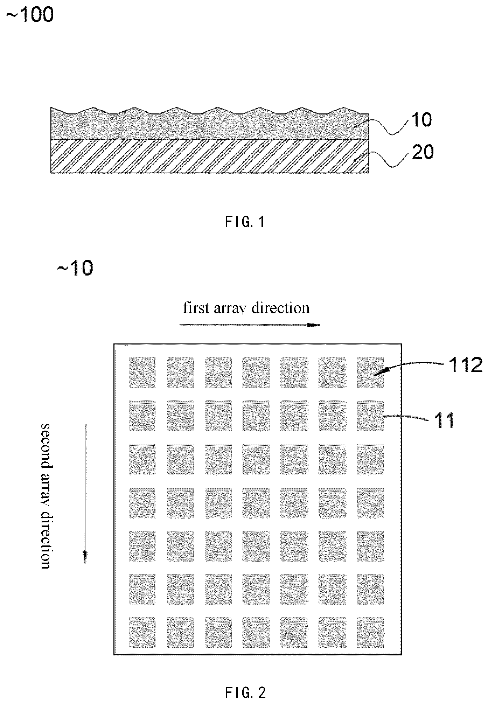

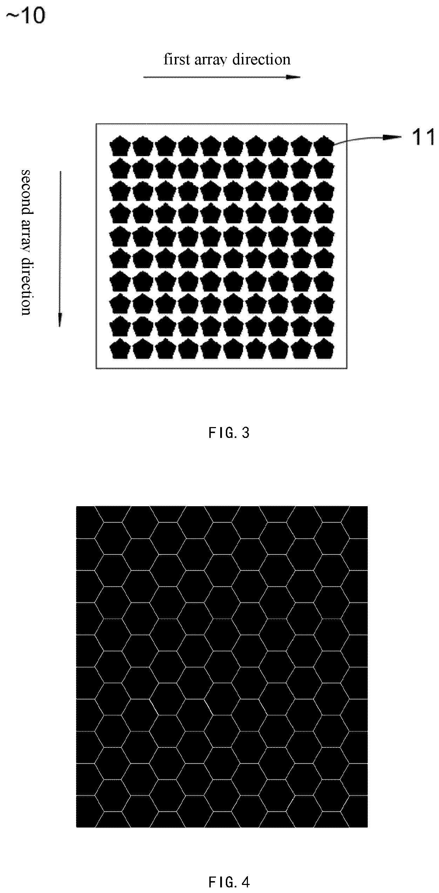

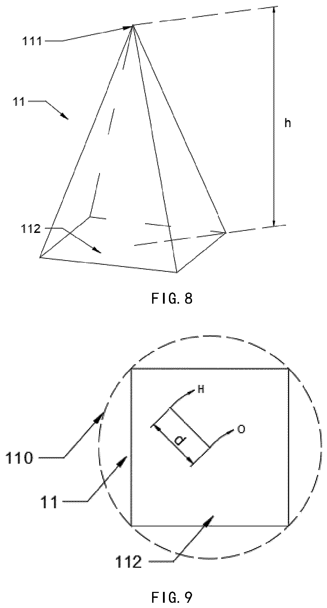

Please refer to FIG. 1, which is the structural diagram of a decorative substrate 100 according to an example of the present disclosure, the decorative substrate 100 includes a base material 20 and a texture layer 10 arranged on the surface of the base material 20. The base material 20 includes, but is not limited to, one or more of plastics, metals, ceramics, and glass. Please refer to FIG. 2, which is the structural diagram of the texture layer 10 according to an example of the present disclosure, the texture layer 10 is provided with a plurality of protrusions 11 arranged in an array, wherein the array direction includes a first array direction and a second array direction. In the present disclosure, a protrusion bottom surface 112 refers to the side surface of the protrusion 11 near the texture layer 10, and the vertex of the protrusion 11 refers to the point at which the protrusion 11 has the greatest distance from the texture layer 10 on the surface away from the texture layer 10. Please refer to FIG. 8, which is the schematic diagram of the stereoscopic structure of a protrusion 11 according to an example of the present disclosure, where protrusion 11 includes a vertex 111 and a protrusion bottom surface 112. The vertex 111 of the protrusion 11 is the highest point of the protrusion 11 relative to the protrusion bottom surface 112. In the examples of present disclosure, the shape of the plurality of the protrusion bottom surface 112 of the protrusion 11 includes, but is not limited to, any of the polygons or circles; polygons may be regular or irregular polygons. As shown in FIG. 2, the shapes of the plurality of the protrusion bottom surfaces 112 corresponding to the plurality of protrusions 11 are quadrilaterals. Please refer to FIG. 3, which is the structural diagram of the texture layer according to an example of the present disclosure, the shapes of the plurality of the protrusion bottom surfaces corresponding to the plurality of protrusions 11 are pentagons. Please refer to FIG. 4, which is the structural diagram of the texture layer according to an example of the present disclosure, the shapes of the plurality of the protrusion bottom surfaces corresponding to the plurality of protrusions are hexagons.

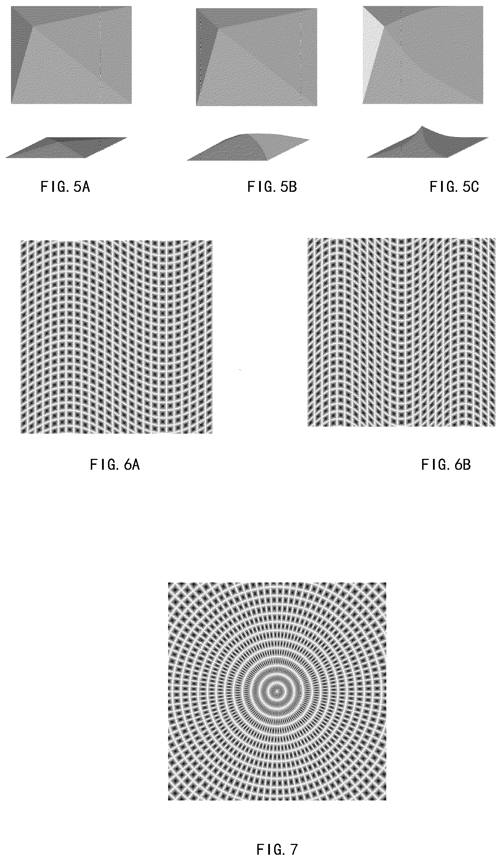

In the examples of the present disclosure, the side surface of protrusion may be any of a plane surface, a straight surface or a curved surface. Please refer to FIGS. 5A, 5B and 5C, FIG. 5A is the structural diagram of a straight-edge protrusion, while FIGS. 5B and 5C are the structural diagram of a curved-edge protrusion. Specifically, the shapes of the plurality of the protrusion bottom surfaces 112 corresponding to the plurality of protrusions 11 in FIGS. 5A, 5B and 5C are all quadrilaterals and the structures of the plurality of protrusions are all quadrangular pyramids. The difference is that in FIG. 5A, the edges of the quadrangular pyramids are straight lines and the side surfaces of the quadrangular pyramids are planes, in FIG. 5B, the edges of the quadrangular pyramids are upward convex arcs, and the side surfaces of the quadrangular pyramids are curved planes, and in FIG. 5C, the edges of the quadrangular pyramids are downward convex arcs, and the side surfaces of the quadrangular pyramids are curved planes.

In some examples of the present disclosure, the array structure formed by the plurality of protrusions may be any of a ring array, a rectangular array, or a curved array, and, correspondingly, the array direction includes any of a straight-line direction, a curved direction, or a circular direction. A schematic diagram of the rectangular array is shown in FIG. 2. Please refer to FIGS. 6A and FIG. 6B, FIG. 6A is the structural diagram of the array arrangement along the S-shaped direction of the protrusions according to an example of the present disclosure, that is, the array direction of the protrusions is an S-shaped curve, and FIG. 6B is the structural diagram of the array arrangement along the M-shaped direction of the protrusions, that is, the array direction of the projection is an M-shaped curve. Please refer to FIG. 7, which provides a structural diagram of the ring array according to an example of the present disclosure.

In order to clearly express the scheme of the present disclosure, some terms of the present disclosure are explained as follows:

Center of the protrusion bottom surface: when the shape of the protrusion bottom surface is a circle, the center of the protrusion bottom surface is the center of the circle; when the shape of the protrusion bottom surface is a polygon, the center of the protrusion bottom surface is the center of the outer circle of the polygon.

The size of the protrusion bottom surface: when the shape of the protrusion bottom surface is circle, the size of the protrusion bottom surface is the radius of the circle; when the shape of the protrusion bottom surface is a polygon, the size of the protrusion bottom surface is the radius of the outer circle of the polygon.

In the present disclosure, the position of the vertices of the plurality of the protrusions gradually vary in the first direction, which can be a variation in the height of the vertex of the protrusion, or a change in the position of the projection of the vertex of the protrusion on the protrusion bottom surface; the first direction can be an array direction of the plurality of protrusions, or any direction in a plane where the texture layer is located. For details, please refer to FIG. 8 again, which is the schematic diagram of the stereoscopic structure of a protrusion 11 according to an example of the present disclosure, where the height h of the vertex of the protrusion 11 refers to the distance between the vertex 111 of protrusion 11 and the protrusion bottom surface 112 of protrusion 11, and the variation in the vertex height h of protrusion 11 refers to the gradual variation in the height h of the vertex of the plurality of protrusions 11 in the first direction, and gradual variation can be gradually increasing or decreasing, or first increasing and then decreasing, or first decreasing and then increasing. Please refer to FIG. 9, which is the structural diagram of the protrusion bottom surface 112 of the protrusion according to an example of the present disclosure. In FIG. 9, the center O of the protrusion bottom surface 112 is the center of the outer circle 110 of the protrusion bottom surface 112, and the projection of the vertex of the protrusion 11 on the protrusion bottom surface 112 is H. The distance between projection H of the vertex 111 of the protrusion 11 on the protrusion bottom surface 112 and center O of the protrusion bottom surface 112 is d, and the change in the position of projection H of the protrusion 11 on the protrusion bottom surface 112 relative to center O of the protrusion bottom surface 112 refers to the gradual variation of distance between projection H of the vertex 111 of the protrusion 11 on the protrusion bottom surface 112 and center O of the protrusion bottom surface 112. The gradual variation can be gradually increasing or decreasing, or first increasing and then decreasing, or first decreasing and then increasing. In the present disclosure, by setting the changes of the protrusion structure in the protrusion array, the texture layer can be changed at different levels in different angles, and the orientation arrangement of the protrusion makes the color gradient more natural, so as to achieve the three-dimensional gradient effect of the decorative substrate.

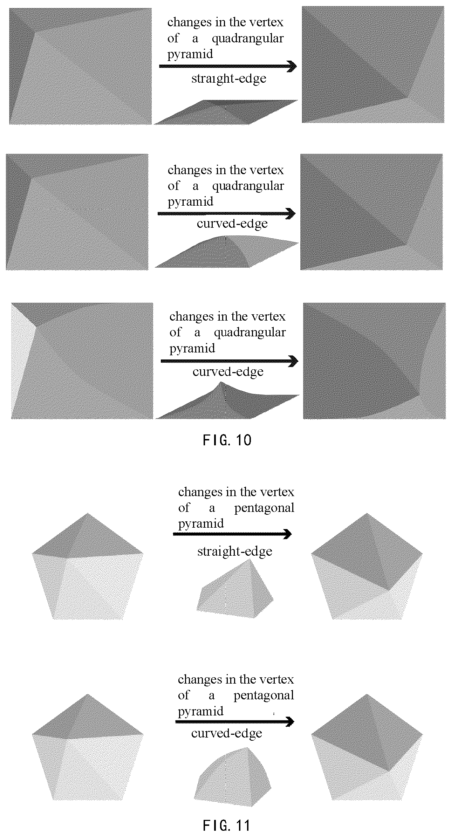

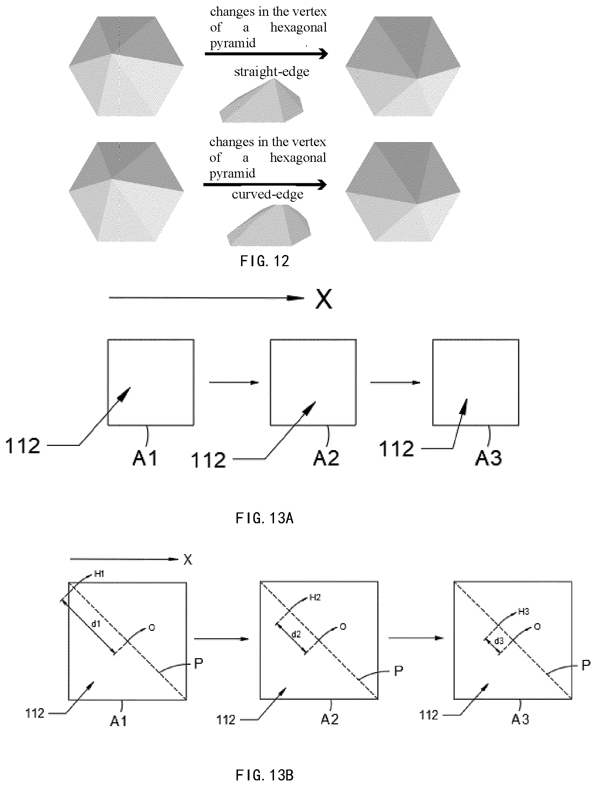

In some examples of the present disclosure, in the first direction, the distances between the projections of the vertices of the plurality of protrusions on the protrusion bottom surfaces and centers of the protrusion bottom surfaces vary gradually. It should be noted that in the present disclosure, the patterns of the plurality of protrusion bottom surfaces in the texture layer are the same or similar, so the position of the center of the protrusion bottom surface is the same in different protrusions. Please refer to FIG. 10, which is the structural diagram of the change of the protrusion structure according to an example of the present disclosure. In FIG. 10, the shape of the protrusion bottom surface is a quadrilateral, and the structure of the protrusion is a quadrilateral pyramid, and the projection position of the vertex of the quadrilateral pyramid on the protrusion bottom surface changes, resulting in the corresponding change of the structure of the quadrilateral pyramid. Please refer to FIG. 11, which is the structural diagram of the change of the protrusion structure according to an example of the present disclosure. In Fig. 11, the shape of the protrusion bottom surface is a pentagon, and the structure of the protrusion is a pentagonal pyramid, and the projection position of the vertex of the pentagonal pyramid on the protrusion bottom surface changes, resulting in the corresponding change of the structure of the pentagonal pyramid. Please refer to FIG. 12, which is the structural diagram of the change of the protrusion structure according to an example of the present disclosure. In FIG. 12, the shape of the protrusion bottom surface is a hexagonal, and the structure of the protrusion is a hexagonal pyramid, and the projection position of the vertex of the hexagonal pyramid on the protrusion bottom surface changes, resulting in the corresponding change of the structure of the hexagonal pyramid. The change of the position of the protrusion vertex relative to the center of the protrusion bottom surface can change the angle and size of the side surface of the protrusion, so that the light reflects different intensity of light at different positions in the texture layer, presenting a change in brightness, and scattering different colors, presenting the effect of gradual color.

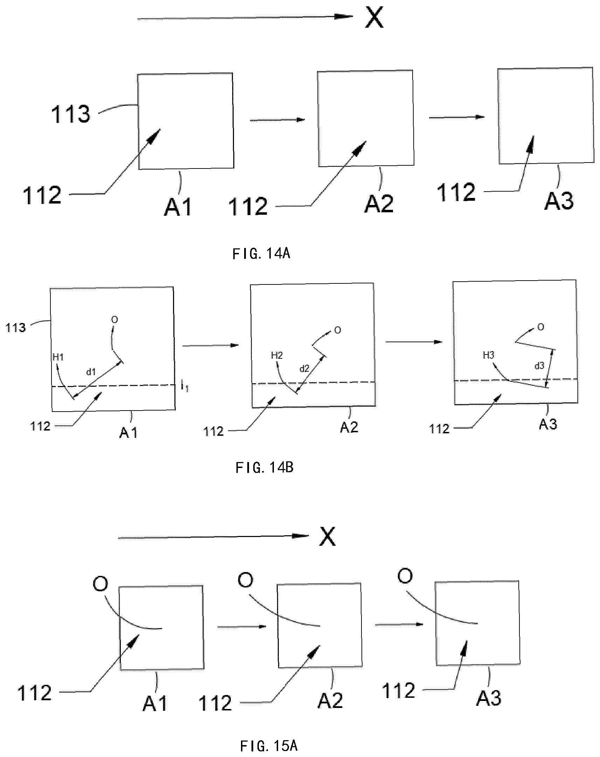

In the present disclosure, the gradual variation of the distances between the projections of the vertices of the plurality of protrusions on the protrusion bottom surfaces and the centers of the protrusion bottom surfaces can be understood as that the projections of the vertices of the plurality of protrusions on the protrusion bottom surfaces are gradually close to or gradually away from the center of the protrusion bottom surface, in the direction of the position change of the vertices of the plurality of protrusions (i.e. the first direction), the arrangement path of the vertices of the plurality of protrusions is obtained by connecting the projections of the vertices of the plurality of protrusions on the protrusion bottom surfaces. The arrangement path can be at least one of the straight path and the curve path. Please refer to FIGS. 13A and 13B, FIG. 13A is the a schematic diagram of the arrangement of a plurality of protrusions A1, A2 and A3 according to an example of the present disclosure, and FIG. 13B is the structural diagram of the position changes of the projections H1, H2 and H3 of the vertices of the plurality of protrusions A1, A2 and A3 in FIG. 13A on the protrusion bottom surfaces. The shapes of the plurality of the protrusion bottom surfaces 112 corresponding to the plurality of protrusions A1, A2 and A3 are quadrilaterals, and the first direction X is the array direction of the protrusions A1, A2 and A3. In the first direction X, the projections H1, H2, and H3 of the vertices of the plurality of protrusions A1, A2 and A3 on the protrusion bottom surfaces are arranged sequentially along the diagonal P of the quadrangles. Please refer to FIGS. 14A and 14B, FIG. 14A is a schematic diagram of the arrangement of the protrusions A1, A2 and A3 according to another example of the present disclosure, FIG. 14B is the structural diagram of the position changes of the projections H1, H2 and H3 of the vertices of the plurality of protrusions A1, A2 and A3 in FIG. 14A on the protrusion bottom surfaces. The shapes of the plurality of the protrusion bottom surfaces 112 corresponding to the plurality of protrusions A1, A2 and A3 are quadrilaterals. Exemplified, in this example, a quadrilateral consists of four sides 113 of the same length. In some examples, a quadrilateral may further include four sides 113 of different lengths. Define the predetermined line segment l1 as a line segment parallel to the sides 113 of the quadrilateral, and in the first direction X, the vertices of the plurality of protrusions A1, A2, and A3 move along the predetermined line segment l1. Exemplified, in this example, the predetermined line segment l1 is located within the protrusion bottom surface 112. In some examples, the predetermined line segment 11 may also be at least partially located within the protrusion bottom surface 112.

In some examples of the present disclosure, in the first direction, the projections of the vertices of the plurality of protrusions on the protrusion bottom surfaces all fall on the same axis passing through the center point of the protrusion bottom surface. The axis passing through the center of the protrusion bottom surface can be, for example, an axis of symmetry of the protrusion bottom surface, or any line segment passing through the center of the protrusion bottom surface (which is the line connecting any two points of the circumference of the protrusion bottom surface). That is, in the first direction, the arrangement path of the vertices of the protrusions is obtained by connecting the projections of the vertices of the plurality of protrusions on the protrusion bottom surfaces, which coincides with the axis of symmetry of the protrusion bottom surface or the line segment passing through the center point of the protrusion bottom surface. In some examples of the present disclosure, the shape of the protrusion bottom surface is a polygon, and in the first direction, the projections of the vertices of the plurality of protrusions on the protrusion bottom surfaces all fall on the same line segment parallel to either side of the polygon of the protrusion bottom surface (which is the line connecting any two points of the circumference of the protrusion bottom surface). The texture layer formed by the array arrangement of protrusions with the above structure can make the color transition of the decorative substrate more natural.

In some examples of the present disclosure, in the first direction, the distances between the projections of the vertices of the plurality of protrusions on the protrusion bottom surfaces and centers of the protrusion bottom surfaces vary gradually. In the first direction, for every 1cm distance, the distance variations between projections of the vertices of the plurality of protrusions on the protrusion bottom surfaces and centers of the protrusion bottom surfaces are in the range of 1 µ m to 200 µm. Taking FIG. 13B as an example, the plurality of protrusions A1, A2, and A3 are in the first direction X. The distances d1, d2, and d3 between the projections H1, H2, and H3 of the vertices of the plurality of protrusions A1, A2, and A3 on the protrusion bottom surfaces 112 and the centers O of the protrusion bottom surfaces 112 gradually decrease in the first direction X. For example, the distance between the projection H1 of the vertex of protrusion A1 on the protrusion bottom surface 112 and the center O of protrusion bottom surface 112 is d1, the distance between the projection H2 of the vertex of protrusion A2 on the protrusion bottom surface 112 and the center O of protrusion bottom surface 112 is d2, and the distance between the projection H3 of the vertex of protrusion A3 on the protrusion bottom surface 112 and the center O of protrusion bottom surface 112 is d3, where d1>d2>d3. It should be noted that the distance between protrusion A1 and protrusion A3 is 1cm (several protrusions can be omitted in the middle), so the distance variation between the projection of the vertex of the protrusion on the protrusion bottom surface and the center of the protrusion bottom surface is in the range of d1 to d3. In some examples of the present disclosure, the first direction is a curve direction, and the distance of 1cm refers to the length of the arc segment being 1cm.

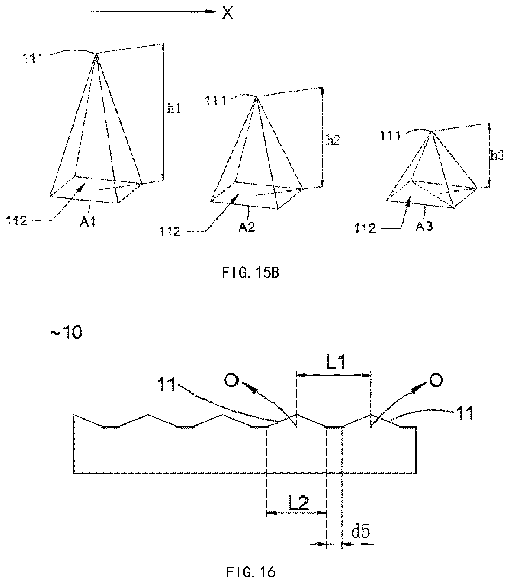

In some examples of the present disclosure, in the first direction, the heights of the vertices of the plurality of protrusions relative to the protrusion bottom surfaces vary gradually. Please refer to FIGS. 15A and 15B. Figure 15A is a schematic diagram of the arrangement of the plurality of protrusions A1, A2, and A3 according to yet another example of the present disclosure. FIG 15B is a structural diagram of the height variations of the vertices 111 of the plurality of protrusions A1, A2, and A3 in FIG 15A. Wherein, the shapes of the plurality of the protrusion bottom surfaces 112 of the plurality of protrusions A1, A2, and A3 are all quadrilaterals, and the first direction X is the array direction of the plurality of protrusions A1, A2, and A3. For example, in this example, the shapes of the plurality of protrusion bottom surfaces 112 corresponding to the plurality of protrusions A1, A2, and A3 are the same, that is, the centers O of the plurality of protrusion bottom surfaces 112 corresponding to the plurality of protrusions A1, A2, and A3 are all located at the intersection of the diagonals of the quadrilateral. In some examples, the shapes of the plurality of protrusion bottom surfaces 112 corresponding to the plurality of protrusions A1, A2, and A3 may also be the same . In the first direction X, the heights h1, h2, and h3 of the vertices 111 of the plurality of protrusions A1, A2, and A3 relative to the protrusion bottom surfaces 112 gradually decrease. The variation in the height of the vertex of the plurality of protrusion relative to the protrusion bottom surface can also change the angle and the size of the side surface of the protrusion, resulting in light to be reflected with different intensities at different positions in the texture layer, presenting a change in brightness and scattering different colors, presenting a gradient effect.

In some examples of the present disclosure, in the first direction, the heights of the vertices of the plurality of protrusions relative to the protrusion bottom surfaces vary gradually. Within every 1 cm distance in the first direction, the height variation of the vertex of the protrusion relative to the protrusion bottom surface is in the range of 0.2 µm to 6 µm. The specific height variation of the vertex of the protrusion relative to the protrusion bottom surface can be, but is not limited to, 0.2 µ m, 0.3 µm, 0.4 µm, 0.5 µm, or 0.6 µm. Please refer to FIG. 15B again, for example, in this example, the texture layer has the plurality of protrusions A1, A2, and A3 in the first direction X, and the heights h1, h2, and h3 of the plurality of protrusions A1, A2, and A3 gradually decrease in the first direction X. For example, the height of the vertex 111 of protrusion A1 relative to the protrusion bottom surface 112 is h1, the height of the vertex 111 of protrusion A2 relative to the protrusion bottom surface 112 is h2, and the height of the vertex 111 of protrusion A3 relative to the protrusion bottom surface 112 is h3, where h1>h2>h3. It should be noted that the distance between protrusion A1 and protrusion A3 is 1cm (several protrusions can be omitted in the middle), so the variations of the heights h1 and h3 of the vertices 111 of protrusions A1 and A3 relative to the protrusion bottom surfaces 112 are in the range of h1 to h3.

In some examples of the present disclosure, the size of the protrusion bottom surface is in the range of 1 µm to 10mm. The specific size of the protrusion bottom surface can be, but is not limited to, 1 µm, 20 µm, 50 µm, 80 µm, 100 µm, 200 µm, 500 µm, 800 µm, 1mm, 1.5mm, 2mm, 3mm, 5mm, 7mm, or 10mm. When the shape of the protrusion bottom surface is a circle, the size of the protrusion bottom surface is the radius of the circle, that is, the radius of the circle is in the range of 1 µm to 10mm; when the shape of the protrusion bottom surface is a polygon, the size of the protrusion bottom surface is the radius of the outer circle of the polygon, that is, the radius of the outer circle of the polygon is in the range of 1 µ m to 10mm. Please refer to FIG. 16, which is the structural diagram of the texture layer 10 according to an example of the present disclosure. In the present disclosure, the distance d5 between adjacent protrusions 11 refers to the difference between the length L1 of the line connecting the centers O of the two protrusion bottom surfaces of adjacent two protrusions 11 and the sizes L2 of the two protrusion bottom surfaces. In other words, the distance d5 between adjacent protrusions 11 is the length of the planar area between the protrusion bottom surfaces 112. In some examples of the present disclosure, the distance d5 between adjacent protrusions 11 is in the range of 1 µm to 10mm. The distance d5 between adjacent protrusions 11 can be, but is not limited to, 1 µm, 20 µm, 50 µm, 80 µm, 100 µm, 200 µm, 500 µm, 800 µm, 1mm, 1.5mm, 2mm, 3mm, 5mm, 7mm, or 10mm. In some examples of the present application, the ratio of the size L2 of the protrusion bottom surface 112 to the distance d5 between adjacent two protrusions 11 is (2 to 3):1. The ratio of the size L2 of the protrusion bottom surface 112 to the distance d5 between adjacent two protrusions 11 can be, but is not limited to, 2:1, 2.5:1, 2.7:1, or 3:1. Controlling the size L2 of the protrusion bottom surface 112 and the distance d5 between adjacent protrusions 11 is beneficial for improving the smoothness of color gradients and making color changes more delicate.

Please refer to FIG. 8 again. In some examples of the present disclosure, the height h of the vertex 111 of the protrusion 11 relative to the protrusion bottom surface 112 is in the range of 0.1 µm to 20 µm. The height h of the vertex 111 of the protrusion 11 relative to the protrusion bottom surface 112 can be, but is not limited to, from 0.1µm to 20 µm. In some examples of the present disclosure, the ratio of the size of the protrusion bottom surface 112 to the height h of the vertex 111 of the protrusion 11 relative to the protrusion bottom surface 112 is greater than or equal to 2. The ratio of the size of the protrusion bottom surface 112 to the height h of the vertex 111 of the protrusion 11 relative to the protrusion bottom surface 112 can be, but is not limited to, 2, 4, 6, 8, 10, or 15. Controlling the size of the protrusion bottom surface 112 and the height h of the vertex 111 of the protrusion 11 relative to the protrusion bottom surface 112 can make the color change effect more significant.

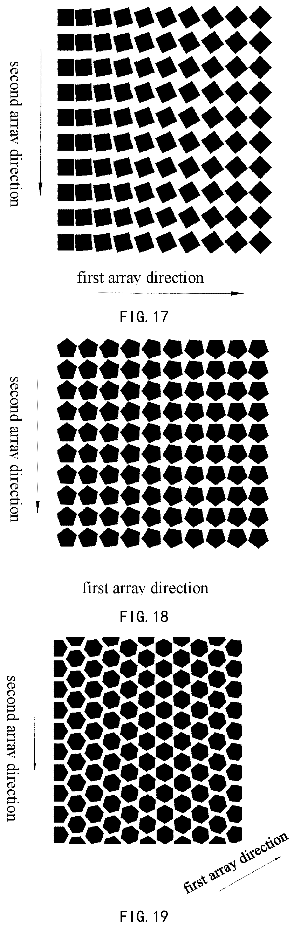

In some examples of the present disclosure, the shape of the protrusion bottom surface is a polygon, and in at least one array direction, the plurality of protrusion bottom surfaces have a relative rotation angle that gradually varying with respect to the array direction. Please refer to FIG. 17, which is the structural diagram of the texture layer according to an example of the present disclosure. In FIG. 17, the shape of the protrusion bottom surface is a quadrilateral, and in the first array direction, the plurality of protrusion bottom surfaces rotate in the direction relative to the first array, and the rotation angles gradually increase. Please refer to FIG. 18, which is the structural diagram of the texture layer according to an example of the present disclosure. In FIG. 18, the shape of the protrusion bottom surface is a pentagonal, and in the first array direction, the plurality of protrusion bottom surfaces rotate in the direction relative to the first array, and the rotation angles gradually increase. Please refer to FIG. 19, which is the structural diagram of the texture layer for an example of the present disclosure. In FIG 19, the shape of the protrusion bottom surface is a hexagonal, and in the first array direction, the plurality of protrusion bottom surfaces rotate in the direction relative to the first array, and the rotation angles gradually increase.

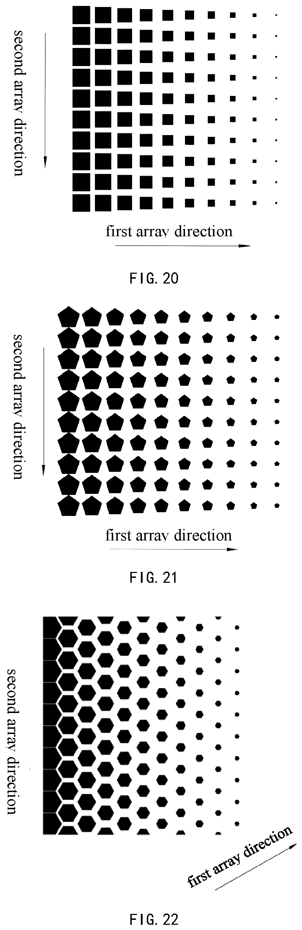

In some examples of the present disclosure, in at least one array direction, the sizes of the plurality of protrusion bottom surfaces corresponding to the plurality of protrusions gradually decreases. Please refer to FIG. 20, which is the structural diagram of the texture layer provided by an example of the present disclosure. In FIG. 20, the shapes of the plurality of protrusion bottom surfaces corresponding to the plurality of protrusions are quadrilaterals. In the first array direction, the sizes of the plurality of protrusion bottom surfaces corresponding to the plurality of protrusions gradually decrease. Please refer to FIG. 21, which is the structural diagram of the texture layer according to an example of the present disclosure. In FIG.21, the shapes of the plurality of protrusion bottom surfaces corresponding to the plurality of protrusions are pentagons. In the first array direction, the sizes of the plurality of protrusion bottom surfaces corresponding to the plurality of protrusions gradually decrease. Please refer to FIG. 22, which is the structural diagram of the texture layer according to an example of the present disclosure. In FIG.22, the shapes of the plurality of protrusion bottom surfaces corresponding to the plurality of protrusions are hexagons. In the first array direction, the sizes of the plurality of protrusion bottom surfaces corresponding to the plurality of protrusions gradually decrease.

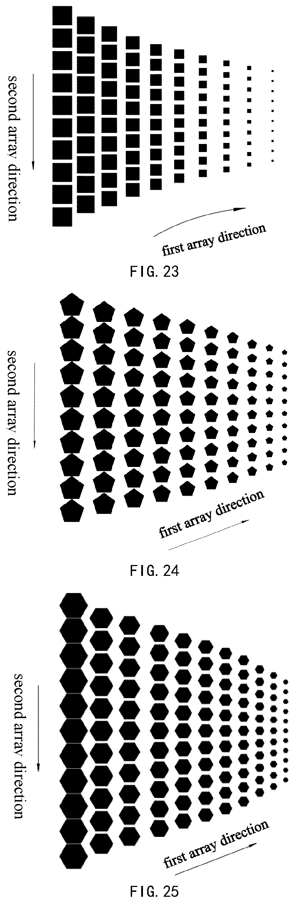

In some examples, the sizes of the plurality of protrusion bottom surfaces corresponding to the plurality of protrusions gradually decrease in the array direction, and the distance between adjacent protrusions gradually increases. Please refer to FIG. 23, which is the structural diagram of the texture layer according to an example of the present disclosure. **In** FIG.23, the shapes of the plurality of protrusion bottom surfaces corresponding to the plurality of protrusions are quadrilaterals, the sizes of the plurality of protrusion bottom surfaces gradually decrease in the first array direction, and the distance between adjacent protrusions gradually increases. Please refer to FIG.24, which is the structural diagram of the texture layer provided by an example of the present disclosure. **In** FIG.24, the shapes of the plurality of protrusion bottom surfaces corresponding to the plurality of protrusions are pentagons, the sizes of the plurality of protrusion bottom surfaces gradually decrease in the first array direction, and the distance between adjacent protrusions gradually increases. Please refer to FIG.25, which is the structural diagram of the texture layer provided by an example of the present disclosure. In FIG.24, the shapes of the plurality of protrusion bottom surfaces corresponding to the plurality of protrusions are hexagons, the sizes of the plurality of protrusion bottom surfaces gradually decrease in the first array direction, and the distance between adjacent protrusions gradually increases. In some examples of the present disclosure, the sizes of the plurality of protrusion bottom surfaces corresponding to the plurality of protrusions gradually decrease in the first array direction, and the size variations of the plurality of protrusion bottom surfaces within every 1cm distance in the first array direction are in the range of 0.1 µm to 100 µm.

In some examples of the present disclosure, the decorative substrate further includes a finishing layer, which includes one or more of a color developing layer, a frosted layer and a glitter layer. In the examples of the present disclosure, the color developing layer may be a coating layer or an ink layer, as long as it has a certain color. In the present disclosure, the texture layer in the decorative film itself has a certain color effect, and the setting of a color development layer can further enrich the color variation. The combination of the color development layer and the texture layer can realize the color change of a single-color coating. The frosted layer has a certain anti-slip function, and the visual effect is softer, which can enrich the appearance of the product. The glitter layer refers to a finishing layer capable of presenting a glitter point effect. In some examples, the glitter layer includes a coating doped with glitter particles, and the setting of the glitter layer can make the decorative substrate have a certain dazzling effect. In some examples, the finishing layer is arranged on the surface of the texture layer. In some examples, the finishing layer is arranged on the surface of the substrate. In some examples, the finishing layer is arranged on the surface of the substrate and the texture layer.

In the decorative substrate provided by the present disclosure, the texture layer has a continuously changing feature structure, which can realize the color change of the decorative substrate at different angles, such as the gradual change from light purple to light yellow in the front observation, and the gradual change from light purple to light blue in the side observation, presenting a dynamic three-dimensional color gradient effect, thus greatly improving the aesthetics of the product.

The present disclosure also provides a method for preparing the decorative substrate. In the examples of the present disclosure, the method for preparing the texture layer includes one or more of etching, UV transfer printing and hot pressing. In some examples, the base material includes a transparent film, for example, the substrate may be a polyester substrate (PET film), a polycarbonate substrate (PC film), a polymethyl methacrylate substrate (PMMA film), and the preparation method of the decorative substrate includes: making a texture master with texture pattern on the mold according to the pattern of the texture layer, transferring the texture master to the surface of the base material to obtain a decorative substrate, and the obtained decorative substrate is a texture film sheet. In some examples, the base material includes a plastic sheet, and the preparation method of the decorative substrate includes: transferring the texture master to the surface of the base material, hot pressing molding to obtain the decorative substrate and the obtained decorative substrate is a textured plastic sheet. In some examples, the base material includes glass, and the preparation method of the decorative substrate includes: preparing a mask plate on the surface of the base material according to the pattern of the texture layer, etching the base material, the etching effect is stronger at a thinner part of the mask plate, and the etching effect is weaker at a thicker part of the mask plate, thereby forming a texture pattern on the surface of the base material to obtain a decorative substrate, and the obtained decorative substrate is textured glass. The preparation method of the decorative substrate provided in the present disclosure has mature technology, simple process, and high product stability, which can improve the yield of the product and is suitable for mass production.

The present disclosure further provides a cover plate including the decorative substrate and the base body of the present disclosure, wherein the base body is used to enhance the structural strength of the cover plate, and the base body may be one or more of plastic, metal, ceramic or glass. The cover plate can show the gradual effect of dynamic color change under different viewing angles, which greatly improves the aesthetics and has a good market prospect. In some examples of the present disclosure, the cover plate can be used for the shell of the communication equipment, and the cover plate has a unique appearance, which can improve the identification of the product.

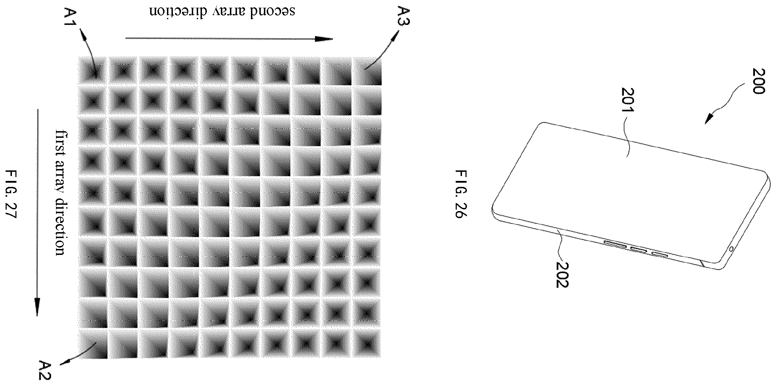

The present disclosure further provides an electronic device including the cover plate. Refer to FIG. 26, which is the structural diagram of the electronic equipment according to an example of the present disclosure, the electronic device 200 includes a display component 201 and a housing 202, wherein the housing 202 includes the cover plate of the present disclosure. In the example of the present disclosure, electronic devices can be mobile phones, computers, watches, U disks, electronic cigarettes, wearable devices, digital cameras, etc.

The following are the further explanations of the implementation of present disclosure through specific examples.

### Example 1

A decorative substrate, the preparation method thereof includes: transferring the pattern data of a texture layer to a computer, conducting photolithographic exposure on a glass plate with uniform photoresist, developing, drying and plasma cleaning, and conducting UV transfer to transfer the texture to a PC sheet to obtain a decorative substrate. The decorative substrate is bonded to the surface of the glass plate through the process of coating, printing, cutting, bonding, etc. to obtain a glass cover plate with texture pattern.

Please refer to FIG. 27, which is the top view of the decorative substrate according to example 1 of the present disclosure. In FIG. 27, the texture layer on the surface of the decorative substrate has a plurality of protrusions, the shape of the protrusion bottom surface is a quadrilateral, the plurality of protrusions are arranged along the direction of a first array and the direction of a second array, and the heights of the vertices of the plurality of protrusions relative to the protrusion bottom surface are the same. The projection of the vertex of the protrusion A1 on the protrusion bottom surface overlaps the center of the protrusion bottom surface, the projection of the vertex of the protrusion A2 on the protrusion bottom surface overlaps with the vertex of the upper right corner of the quadrilateral of the protrusion bottom surface, and the projection of the vertex of the protrusion A3 on the protrusion bottom surface overlaps with the vertex of the upper right corner of the quadrilateral of the protrusion bottom surface. Taking the protrusion A1 as the starting point, in the direction of the first array, the projections of the vertices of the plurality of protrusions on the protrusion bottom surfaces gradually deviate from the centers of the protrusion bottom surfaces, that is, the distances between the projections of the vertices of the plurality of protrusions on the protrusion bottom surfaces and the centers of the protrusion bottom surfaces gradually increase. Similarly, taking the protrusion A1 as the starting point, in the direction of the second array, the projections of the vertices of the plurality of protrusions on the protrusion bottom surfaces gradually deviate from the centers of the protrusion bottom surfaces, that is, the distances between the projections of the vertices of the plurality of protrusions on the protrusion bottom surfaces and the centers of the protrusion bottom surfaces gradually increase.

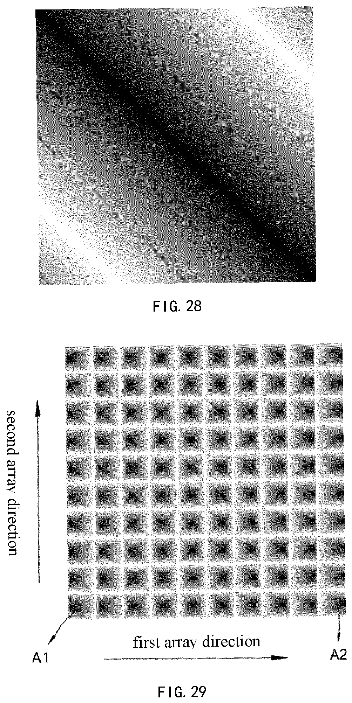

Please refer to FIG. 28, which is the effect diagram of the decorative substrate according to example 1 of the present disclosure. It can be seen from FIG. 28 that the outer surface of the texture unit has multi-level structural changes, thus enriching the color gradient.

### Example 2

A decorative substrate, the preparation method thereof includes: transferring the pattern data of a texture layer to a computer, conducting photolithography exposure and development on a glass plate with uniform photoresist, forming the texture pattern on the surface of photoresist, placing the glass plate with photoresist in a chemical liquid etching tank, due to the protective effect of photoresist on glass, the thick glue part has a long etching resistance time, and the thin glue part has a short etching resistance time, which leaks out of the glass layer before the thick glue part, thus forming an uneven textural structure, so that the texture is completely copied to the glass surface and forming the decorative substrate.

Please refer to FIG. 29, which is the top view of the decorative substrate according to example 2 of the present disclosure. In FIG. 29, the texture layer on the surface of the decorative substrate has a plurality of protrusions, the shape of the protrusion bottom surface is a quadrilateral, and the plurality of protrusions are arranged along the direction of a first array and the direction of a second array. The projection of the vertex of the protrusion A1 on the protrusion bottom surface falls on the side length to the left of the quadrangle on the protrusion bottom surface, and the projection of the vertex of the protrusion A2 on the protrusion bottom surface falls on the side length to the right of the quadrangle on the protrusion bottom surface. Taking the protrusion A1 as the starting point, in the direction of the first array, the projections of the vertices of the plurality of protrusions on the protrusion bottom surfaces first gradually approach the centers of the protrusion bottom surfaces and then gradually deviate from the centers of the protrusion bottom surface, that is, distances between the projections of the vertices of the plurality of protrusions on the protrusion bottom surfaces and the centers of the protrusion bottom surfaces first gradually decrease and then gradually increase. In the direction of the second array, the structures of the plurality of protrusions are the same.

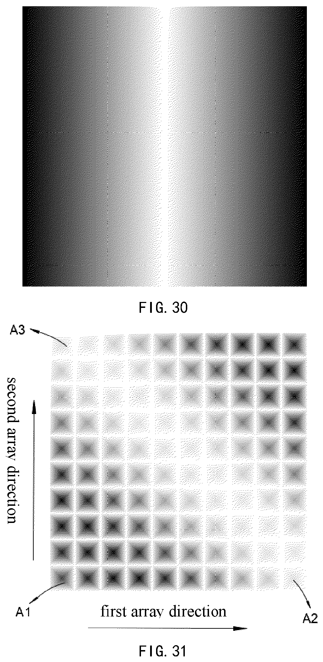

Please refer to FIG. 30, which is the effect diagram of the decorative substrate according to example 2 of the present disclosure. It can be seen from FIG. 30 that the outer surface of the texture unit has multi-level structural changes, thus enriching the color gradient.

### Example 3

A decorative substrate, please refer to FIG. 31, which is the top view of the decorative substrate according to example 3 of the present disclosure. In FIG. 31, the texture layer on the surface of the decorative substrate has a plurality of protrusions, the shape of the protrusion bottom surface is a quadrilateral, the plurality of protrusions are arranged along the direction of a first array and the direction of a second array, and the projection positions of the vertices of the plurality of protrusions on the protrusion bottom surfaces are the same. Among them, the height of the vertex of the protrusion A1 relative to the protrusion bottom surface is h1, the height of the vertex of the protrusion A2 relative to the protrusion bottom surface is h2, and the height of the vertex of the protrusion A3 relative to the protrusion bottom surface is h3, where h1>h2 and h1>h3. Taking the protrusion A1 as the starting point, in the direction of the first array, the heights of the vertices of the plurality of protrusions relative to the protrusion bottom surface first gradually increase and then gradually decrease. In the direction of the second array, taking the protrusion A1 as the starting point, the heights of the vertices of the plurality of protrusions relative to the protrusion bottom surface gradually decrease.

Please refer to FIG. 28, which is the effect diagram of the decorative substrate provided in example 1 of the present disclosure. As can be seen from FIG. 28, the outer surface of the texture unit has multi-level structural changes, thus enriching the color gradient.

### Example 4

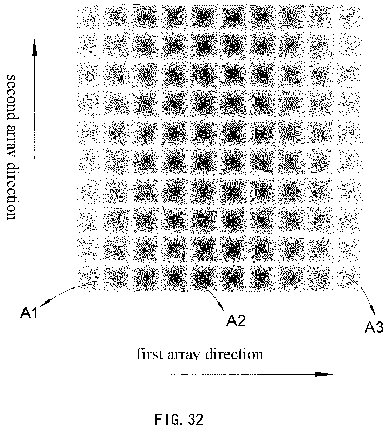

A decorative substrate, please refer to FIG. 32, which is the top view of the decorative substrate provided in example 4 of the present disclosure. In FIG. 32, the texture layer on the surface of the decorative substrate has a plurality of protrusions, the shape of the protrusion bottom surface of the protrusion is a quadrilateral, the plurality of protrusions are arranged along the direction of a first array and the direction of a second array, and the projection positions of the vertices of the plurality of protrusions on the protrusion bottom surfaces are the same. Among them, the height of the vertex of the protrusion A1 relative to the protrusion bottom surface is h1, the height of the vertex of the protrusion A2 relative to the protrusion bottom surface is h2, and the height of the vertex of the protrusion A3 relative to the protrusion bottom surface is h3, where h2>h1 and h2>h3. Taking the protrusion A1 as the starting point, in the direction of the first array, the heights of the vertices of the plurality of protrusions relative to the protrusion bottom surface first gradually increase and then gradually decrease; in the second array direction, the structure of the plurality of protrusions is the same.

Please refer to FIG. 30, which is the effect diagram of the decorative substrate provided in example 2 of the present disclosure. As can be seen from FIG. 30, the outer surface of the texture unit has multi-level structural changes, thus enriching the color gradient.

The above example only expresses one example of the present disclosure, and the description thereof is relatively specific and detailed, but should not be construed as limiting the scope of the present disclosure. It should be noted that for those skilled in the art, several modifications and improvements can be made without departing from the design concept of the present disclosure, and these all fall within the scope of the present disclosure. Therefore, the scope of the present disclosure is defined by the appended claims.

## Claims

1. A decorative substrate (100), the decorative substrate (100) comprising a base material (20) and a texture layer (10) arranged on a surface of the base material (20), the texture layer (10) being provided with a plurality of protrusions (11) arranged in an array, and a first direction (X) being any direction in a plane where the texture layer (10) is located;
the protrusion (11) comprises a protrusion bottom surface (112) and a vertex (111), in the first direction (X), distances (d) between projections (H) of the vertices (111) of the plurality of protrusions (11) on the protrusion bottom surfaces (112) and centers (O) of the protrusion bottom surfaces (112) varying gradually; and/or
in the first direction (X), the heights (h) of the vertices (111) of the plurality of protrusions (11) relative to the protrusion bottom surfaces (112) varying gradually.

2. The decorative substrate (100) according to claim 1, wherein the heights of the vertices (111) of the plurality of protrusions (11) relative to the protrusion bottom surfaces (112) vary gradually in the first direction (X); and within every 1 cm distance in the first direction (X), variations of the heights of the vertices (111) of the plurality of protrusions (11) relative to the protrusion bottom surfaces (112) are in the range of 0.2µm to 6µm.

3. The decorative substrate (100) according to claim 1, wherein the shape of the protrusion bottom surface (112) comprises any one of a polygon or a circle; in the first direction (X), distances (d) between projections (H) of the vertices (111) of the plurality of protrusions (11) on the protrusion bottom surfaces (112) and centers (O) of the protrusion bottom surfaces (112) varying gradually; and within every 1 cm distance in the first direction (X), variations of the distances (d) between projections (H) of the vertices (111) of the plurality of protrusions (11) on the protrusion bottom surfaces (112) and centers (O) of the protrusion bottom surfaces (112) are in the range of 1µm to 200µm.

4. The decorative substrate (100) according to claim 1, wherein a distance (d5) between the adjacent protrusions (11) is in the range of 1µm to 10mm; the shape of the protrusion bottom surface (112) is circular, and the radius of the protrusion bottom surface (112) is in the range of 1µm to 10mm, or the shape of the protrusion bottom surface (112) is polygonal, and the radius of the outer circle (110) of the protrusion bottom surface (112) is in the range of 1µm to 10mm.

5. The decorative substrate according to claim 1, wherein the shape of the protrusion bottom surface (112) is a circle, and the ratio of the radius of the protrusion bottom surface (112) to a distance (d5) between the adjacent protrusions (11) is (2 to 3):1; or the shape of the protrusion bottom surface (112) is a polygon, and the ratio of the radius of the outer circle (110) of the protrusion bottom surface (112) to a distance (d5) between the adjacent protrusions (11) is (2 to 3): 1.

6. The decorative substrate (100) according to claim 1, wherein the height (h) of the vertex (111) of the protrusion relative to the protrusion bottom surface (112) is in the range of 0.1µm to 20µm.

7. The decorative substrate (100) according to claim 1, wherein the shape of the protrusion bottom surface (112) is a circle, and radii of the plurality of protrusion bottom surfaces (112) gradually vary in a second direction (Y); or the shape of the protrusion bottom surface (112) is a polygon, and the radii of the outer circles (110) of the plurality of protrusion bottom surfaces (112) gradually vary in the second direction (Y); the second direction (Y) is any direction in the plane where the texture layer (10) is located.

8. The decorative substrate (100) according to claim 1, wherein the shape of the protrusion bottom surface (112) is a polygon, the plurality of protrusion bottom surfaces (112) have a first array direction and a second array direction, the first array direction is perpendicular to the second array direction, and the plurality of protrusion bottom surfaces (112) have relative rotation angles that gradually vary relative to the first array direction or relative to the second array direction.

9. The decorative substrate (100) according to claim 1, wherein a side surface of the protrusion (11) is any one of a flat surface, a straight surface or a curved surface.

10. The decorative substrate (100) according to claim 1, wherein the vertices (111) of the plurality of protrusions (11) are connected at the projections (H) of the protrusion bottom surface (112) to form an arrangement path of the vertices (111) of the protrusions (11) in the first direction (X), and the arrangement path comprises a straight path and/or a curved path.

11. The decorative substrate (100) according to claim 10, wherein the first array direction is defined as an array direction of the plurality of protrusions (11), the shape of the protrusion bottom surface (112) is a quadrilateral, and in the first array direction, the projections (H) of the vertices (111) of the plurality of protrusions (11) on the protrusion bottom surfaces (112) are arranged in sequence along a diagonal of the quadrilateral.

12. The decorative substrate (100) according to claim 10, wherein the first array direction is defined as the array direction of the plurality of protrusions (11), and the shape of the protrusion bottom surface (112) is a quadrilateral, in the first array direction, the projections (H) of the vertices (111) of the plurality of protrusions (11) on the protrusion bottom surfaces (112) are arranged in sequence along a predetermined line segment (l1), and the predetermined line segment (l1) is a line segment parallel to a side length (113) of the quadrilateral.

13. The decorative substrate (100) according to claim 10, wherein the projections (H) of the vertices (111) of the plurality of protrusions (11) on the protrusion bottom surfaces (112) fall on the same axis passing through the center (O) of the protrusion bottom surface (112) in the first direction (X).

14. The decorative substrate (100) according to claim 13, wherein the axis comprises the axis of symmetry of the protrusion bottom surface (112) or a line segment passing through the center (O) of the protrusion bottom surface (112), wherein the line segment is a line connecting any two points on the circumference of the protrusion bottom surface (112).

15. The decorative substrate (100) according to claim 1, wherein the plurality of protrusion bottom surfaces (112) have a first array direction and a second array direction, the first array direction is perpendicular to the second array direction, the sizes of the protrusion bottom surfaces (112) of the plurality of the protrusions (11) gradually decrease in the first array direction and/or the second array, and the distances (d5) between the adjacent convex surfaces (11) gradually increase.

16. The decorative substrate (100) according to claim 1, wherein the plurality of protrusion bottom surfaces (112) have a first array direction and a second array direction, the first array direction is perpendicular to the second array direction, in the first array direction, the sizes of the plurality of protrusion bottom surfaces (112) of the plurality of protrusions (11) gradually decrease, and within every 1 cm distance in the first array direction, variations of the size of the plurality of protrusion bottom surfaces (112) of the plurality of protrusions (11) are in range of 0.1 µm to 100µm.

17. The decorative substrate (100) according to claim 1, wherein the decorative substrate further comprises a finishing layer, the finishing layer comprise one or more of a color developing layer, a frosted layer, and a glitter layer, and the finishing layer is arranged on the surface of the texture layer (10) and/or the base material (20).

18. A method for preparing a decorative substrate (100), comprising the following steps:
forming a texture layer (10) on a surface of a base material (20) to obtain a decorative substrate (100), a preparation method of the texture layer (10) comprising one or more of transfer printing, etching, and hot pressing molding; the surface of the texture layer (10) being provided with a plurality of protrusions (11) arranged in an array; a first direction (X) being any direction in a plane where the texture layer (10) is located; and
protrusion (11) comprises a protrusion bottom surface (112) and a vertex (111), in the first direction (X), distances (d) between projections (H) of the vertices (111) of the plurality of protrusions (11) on the protrusion bottom surfaces (112) and centers (O) of the protrusion bottom surfaces (112) varying gradually;
and/or in the first direction (X), heights (h) of the vertices (111) of the plurality of protrusions (11) relative to the protrusion bottom surfaces (112) varying gradually.

19. A cover plate, comprising the decorative substrate according to any one of claims 1-17 and a base body, the decorative substrate being arranged on the surface of the base body.

20. An electronic device (200), comprising the cover plate according to claim 19.
